# EUROPÄISCHE PATENTSCHRIFT

(11) **EP 0 884 848 B1**
(45) Veröffentlichungstag und Bekanntmachung des Hinweises auf die Patenterteilung: **25.08.2004**
(21) Anmeldenummer: 98110245.2
(22) Anmeldetag: 04.06.1998
(51) Int. Cl.: H03K 19/0185, H03K 17/687, H03K 17/14

(54) **Schaltungsanordnung zum Erzeugen digitaler Signale**
Circuit for producing digital signals
Circuit pour générer des signaux numériques

(30) Priorität: 10.06.1997 DE 19724451
(43) Veröffentlichungstag der Anmeldung: 16.12.1998
(73) Patentinhaber: Infineon Technologies AG, 81669 München (DE)
(72) Erfinder: Sichert, Christian, 81827 München (DE); Kaiser, Robert, 86916 Kaufering (DE); Wirth, Norbert, 85716 Unterschleissheim (DE)
(74) Vertreter: Epping Hermann & Fischer

(56) Entgegenhaltungen:
- US-A- 4 001 606
- US-A- 5 530 379
- US-A- 5 539 334
- PATENT ABSTRACTS OF JAPAN vol. 015, no. 058 (E-1032), 12. Februar 1991 & JP 02 285811 A (SEIKO EPSON CORP), 26. November 1990
- PATENT ABSTRACTS OF JAPAN vol. 015, no. 375 (E-1114), 20. September 1991 & JP 03 149876 A (HITACHI LTD;OTHERS: 01), 26. Juni 1991

## Beschreibung

Die Erfindung betrifft eine Schaltungsanordnung zum Erzeugen digitaler Signale mit einer Schaltstufe, der mindestens ein Referenzsignal zugeführt wird.

Die digitale Signalverarbeitung weist gegenüber der Verarbeitung analoger Signale den Vorzug auf, dass die zu verarbeitenden Signale, beispielsweise binäre Signale, einen erheblich größeren Störabstand aufweisen. Schon geringe Störungen können ein analoges Signal irreversibel verfälschen. Auch digitale Signale unterliegen vielfältigen Störungen, wie z. B. Rauschen oder überlagerten Spannungsspitzen. Das Ausmaß dieser Störungen hängt in der Regel von Art und Umfang der digitalen Signalverarbeitung ab. In aufeinanderfolgenden Signalverarbeitungsstufen können sich Störungen derart auf integrieren, dass auch bei binären Signalen das eigentliche Signal nicht mehr eindeutig bestimmt werden kann. An bestimmten Punkten der Signalverarbeitung, beispielsweise an den Eingängen eines Logikbausteines, werden die digitalen Signale Vorrichtungen zum Erzeugen digitaler Signale, wie beispielsweise Signalverstärkern, zugeführt. Diese Vorrichtungen, die in der Digitaltechnik auch unter der Bezeichnung Receiver oder Signalregenerierer bekannt sind, dienen der Pegelregenerierung der digitalen Signale. Dazu werden im Allgemeinen die Spannungspegel der einzelnen Signale, solange sie innerhalb eines Toleranzbereiches liegen und einem bestimmten Signalwert zugeordnet werden können, auf den vereinbarten Sollwert angehoben bzw. herabgesetzt. Welcher Toleranzbereich dabei heranzuziehen ist, hängt von dem gewählten Standard ab, der für die Schaltung zur Signalverarbeitung gewählt wurde.

Von der Vielzahl der Logikstandards seien beispielhaft hier zwei erwähnt. Der LVTTL-Standard (LVTTL = Low Voltage Transitor-Transistor-Logik) sieht zur Darstellung der binären Zustände "low" und "high" die Spannungspegel 0,8 V und 2,0 V vor.

Beim SSTL-Standard wird der Signalwert "high" durch Erhöhung des Signals gegenüber einer Referenzspannung um 0,4 V und der Signalwert "low" durch Verringerung des Signals gegenüber der Referenzspannung um 0,4 V ausgedrückt.

Die Signalregenerierer passen jedoch nicht nur die in einem Toleranzbereich liegenden binären Signalwerte an diese Spannungspegel an. Gleichzeitig sorgen sie bei einem Wechsel von einem Signalwert zum anderen, beispielsweise von low" nach high", für einen möglichst schnellen Wechsel der Signalpegel. Idealerweise sind die Flanken eines nach der Zeit aufgetragenen Spannungssignals der binären Werte möglichst steil.

Signalregenerierer werden überall dort eingesetzt, wo digitale Werte auszuwerten sind und sind flexibel einsetzbar. Sie finden sich beispielsweise auch in Speichern zur Auffrischung der Adress-Steuersignale, RAS und CAS, Enable-Signalen und Ähnlichem.

Der Einsatz eines Signalregenerierers bei verschiedenen Logik-Standards ist ohne Weiteres jedoch nicht möglich. Signalregenerierer können auch in Halbleiterchips eingesetzt werden, die beispielsweise zu zwei Logikstandards kompatibel sind. Für jeden Standard ist dann jeweils ein Signalregenerierer vorzusehen. Der Aufwand dafür ist natürlich erheblich. Durch die dann ebenfalls steigende Anzahl von Verbindungen ist die Gefahr der gegenseitigen Beeinflussung der internen Spannungen auf dem Chip groß.

Aus der DE 33 47 484 C2 ist eine Schaltungsanordnung zum anpassen von Eingangssignalen an einen logischen Signalpegel zur Verwendung in logischen Schaltungen und Prozessdaten-Schaltungen bekannt, die einen Komperator mit einem positiven und einen negativen Eingang aufweist. Die Eingangssignale werden über eine externe Eingangsklemme zugeführt.

Die JP 1-319322 A in: Patents Abstract of Japan, Section E. Vol. 14 (1990) Nr. 125 (E-900) beschreibt einen Schaltkreis zur Pegelumsetzung mit einem Operationsverstärker, der über eine Schaltvorrichtung wahlweise mit einem Eingangsanschluß oder Masse verbunden werden kann. Über den nichtinvertierenden Eingang des Operationsverstärkers wird eine Referenzspannung zugeführt.

In der US-A-5 530 37.9 ist eine Schaltungsanordnung gezeigt, die sowohl LVTTL-Signalpegel als auch GTL-(Gunnig Transceiver Logic)-Signalpegel empfangen kann. Die Schaltstufe sieht verschiedene Schalter vor, die Kanalstrecken bzw. Gate-Anschlüsse der in der Schaltstufe enthaltenen MOS-Transistoren an verschiedene Versorgungsspannungspotentiale schalten.

In Patent Abstract of Japan, Band 015, Nr. 058 (E-1032), vom 12. Februar 1991 (JP-A-02-285811) ist ein Konzept für eine integrierte Schaltung beschrieben, bei der die internen Schaltungselemente bei 3 V Versorgungsspannung betrieben werden, während die Ein-/Ausgangsschaltstufen wahlweise bei 3 V oder 5 V betrieben werden können. Hierzu sind die Ein/Ausgangsschaltstufen versorgungspotentialseitig mit einem Umschalter versehen, der wahlweise an den Anschluß für das entsprechende Versorgungspotential gelegt wird.

In der US-A-4 001 606 ist eine Schaltung beschrieben, die außerhalb der Versorgungsspannung liegende Eingangssignale empfangen kann. Die Schaltung weist einen Umschalter auf, der komplementäre, kanalseitig parallel geschaltete Transistoren enthält, um das Eingangssignal weiterzuleiten. Der Umschalter wird von einer zwei Strompfade enthaltenden Stufe angesteuert, die ein von komplementären Signalen angesteuertes Transistorpaar aufweist und ein gateseitig kreuzgekoppeltes Transistorpaar aufweist.

In der US-A-5 539 334 ist eine Spannungspegelverschiebeschaltung gezeigt, die zwischen zwei Versorgungsspannungsanschlüsse zwei Strompfade vorsieht, die jeweils in Reihe geschaltete Kanalstrecken von MOS-Transistoren aufweisen. Ein Transistorpaar weist kreuzgekoppelte Gate-Anschlüsse auf. Ein anderes Transistorpaar wird von komplementären Eingangssignalen angesteuert. Weitere Transistorpaare werden von einem zusätzlichen Versorgungspotential angesteuert. Der Ausgangsanschluß ist an die kreuzgekoppelten Transistoren angeschlossen.

Aufgabe der vorliegenden Erfindung ist es, eine Schaltungsanordnung mit einer Schaltstufe zum Erzeugen eines digitalen Signals anzugeben, die bei verschiedenen Standards betrieben werden kann und die eine geringe Empfindlichkeit gegenüber Spannungsschwankungen der ihr zugeführten Spannungen aufweist.

Diese Aufgabe wird durch die Merkmale des Patentanspruches 1 gelöst.

Da die erfindungsgemäße Schaltungsanordnung nur eine Schaltstufe zum Erzeugen digitaler Signale vorsieht, können die Kosten gegenüber Lösungen mit zwei solcher Vorrichtungen gesenkt werden. Zudem lässt sich Chipfläche einsparen. Weiterhin bietet die Erfindung den Vorteil, dass aufgrund von Koppelelementen die interne Referenzspannung stark mit den internen Spannungen verkoppelt ist. Die erfindungsgemäße Schaltungsanordnung weist zudem eine geringe Empfindlichkeit gegenüber Schwankungen der Versorgungsspannung auf.

Vorteilhafte Aus- und Weiterbildungen der Erfindung sind in den Unteransprüchen gekennzeichnet.

Die Erfindung wird nachfolgend anhand von in den Figuren der Zeichnung dargestellten Ausführungsbeispielen näher erläutert. Gleiche Elemente sind mit gleichen Bezugszeichen versehen. Es zeigt:
Figur 1 ein Blockschaltbild der erfindungsgemäßen Schaltungsanordnung und
Figur 2 eine detailliertere Schaltung zur Bereitstellung einer internen Referenzspannung.

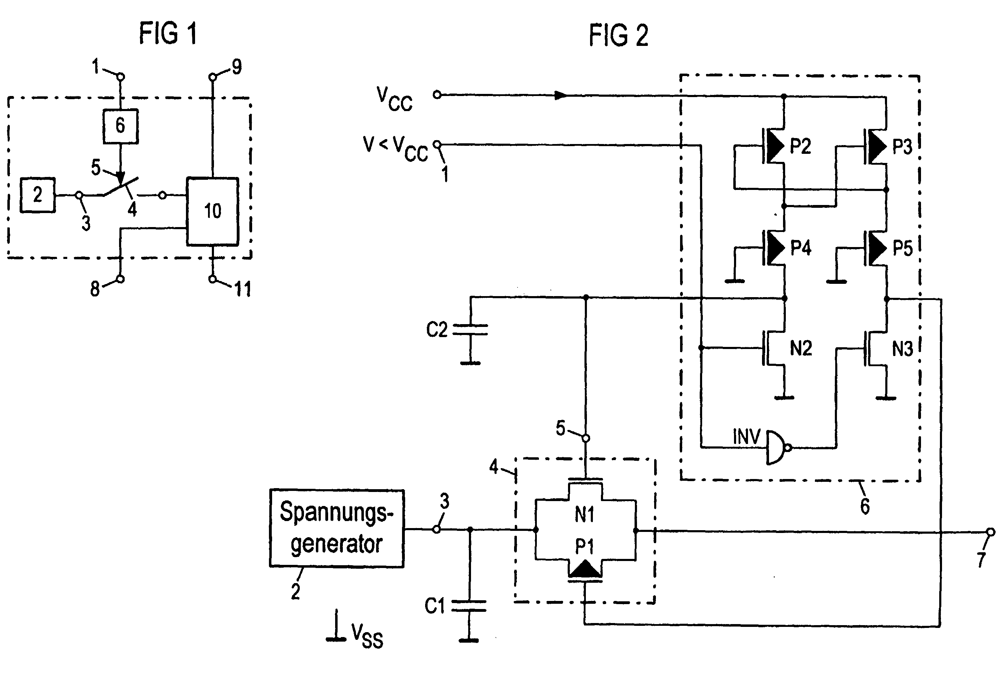

Gemäß Figur 1 enthält die erfindungsgemäße Schaltungsanordnung eine Vorrichtung zum Erzeugen digitaler Signale 10 mit durch einen Eingangs- und einen Ausgangsanschluss 9, 11 stellvertretend dargestellten Ein- und Ausgängen. Die Vorrichtung zum Erzeugen digitaler Signale 10 ist mit einem Spannungsanschluss 8 verbunden, über den eine externe Referenzspannung V_{ref,ext.} der Vorrichtung 10 zuführbar ist. Des Weiteren ist sie über einen Schalter 4 mit dem Ausgang 3 eines Spannungsgenerators 2 verbunden. Der Spannungsgenerator 2 erzeugt eine interne Referenzspannung V_{ref,int.}, die unabhängig von der anliegenden Last oder sonstigen Störgrößen, wie beispielsweise Schwankungen der Betriebsspannung, möglichst konstant sein soll.

Der Schalter 4 ist über einen Steuerkontakt 5 mit einem Pegelumsetzer 6 verbunden. Er ist mit einem Schaltsignal, das an einen Schalteingang 1 dem Pegelumsetzer 6 zuführbar ist, ansteuerbar. Der Pegelumsetzer 6 sorgt dafür, dass auch bei schwachen Schaltsignalen der Schalter 4 voll ausgesteuert wird. Sein Aufbau und seine Funktionsweise sind weiter unten näher erläutert.

Ein am Eingang 9 der Vorrichtung 10 anliegendes digitales Signal wird durch einen Vergleich mit einem Referenzsignal als low" oder high" bewertet. Liegt der Spannungspegel des digitalen Signals am Eingang unter dem Spannungspegel der Referenzsignals, so erzeugt die Vorrichtung 10 an ihrem Ausgang 11 ein Low"-Signal mit beispielsweise 0 V. Liegt der Spannungspegel des digitalen Signals über dem Spannungspegel de Referenzsignals, so steht dagegen am Ausgang 11 der Vorrichtung 10 ein high"-Signal mit beispielsweise 2,5 V zur Verfügung. Durch die Wahl des Spannungspegels des Referenzsignals wird also die Umschaltschwelle zwischen low" und high" eingestellt. Dadurch ist es möglich, die Vorrichtung 10 bei verschiedenen Logikstandards einzusetzen.

Die erfindungsgemäße Schaltungsanordnung nach Figur 1 lässt sich bei zwei verschiedenen Logikstandards betreiben.

In einer ersten Betriebsart gehören die Signale am Eingang 9 dem LVTTL-Standard an. Als Referenzsignal dient dann die intern erzeugte Referenzspannung V_{ref,int.}. Das Schaltsignal am Schalteingang 1 des Pegelumsetzers 6 ist so zu wählen, dass der Schalter 4 geschlossen ist. Die interne Referenzspannung V_{ref,int.} liegt an der Vorrichtung 10 an, während der Spannungsanschluss 8 nicht belegt ist, also keine Spannung führt.

In einer zweiten Betriebsart entsprechen die Signale am Eingang 9 einem vom LVTTL-Standard unterschiedlichen anderen Logik-Standard. Beispielsweise liegen am Eingang 9 SSTL-Signale an.
Hier ist der Schalter 4 so anzusteuern, dass keine Verbindung zwischen dem Spannungsgenerator 2 und der Vorrichtung 10 besteht. Am Spannungsanschluss 8 liegt die externe Referenzspannung V_{ref,ext.} an, die beispielsweise ein externer Spannungsgenerator liefert, der auch zur Spannungsversorgung anderer Schaltungseinheiten vorgesehen ist. Dadurch, dass die externe Referenzspannung V_{ref,ext.} von extern zugeführt wird und nicht intern erzeugt wird, ist der Einsatz der erfindungsgemäßen Schaltungsanordnung bei verschiedenen Logikstandards sehr einfach möglich. Es ist kein zusätzlicher Spannungsgenerator zur Erzeugung der externen Referenzspannung V_{ref,ext.} für die erfindungsgemäße Schaltungsanordnung notwendig.

Die Teilanordnung mit dem Spannungsgenerator 2, dem Schalter 4 und dem Pegelumsetzer 6 aus der Schaltungsanordnung nach Figur 1 ist in Figur 2 detaillierter dargestellt. Der Schalter 4 besteht hier aus zwei Transistoren unterschiedlichen Leitungstyps N1 und P1, die kanalseitig parallelgeschaltet sind. Über die parallelgeschalteten Kanalstrecken ist eine Verbindung des Ausgangsanschlusses 3 des Spannungsgenerators 2 mit einem weiteren Spannungsanschluss 7 der Vorrichtung 10 herstellbar. Zwischen dem Ausgangsanschluss 3 des Spannungsgenerators 2 und einem ersten Versorgungspotential V_{SS} ist eine Ausgangs-Koppelkapazität C1 geschaltet.

Der Schalter 4 ist über den Pegelumsetzer 6 ansteuerbar. Der Pegelumsetzer 6 weist zwei Transistoren vom p-Kanaltyp P2 und P3 auf, die mit ihren Source-Anschlüssen jeweils an einem zweiten Versorgungspotential V_{CC} angeschlossen sind. Ihre Drain-Anschlüsse sind jeweils mit den Gate-Anschlüssen des anderen verbunden, so dass eine Kreuzkopplung entsteht. Weiterhin sind die Drain-Anschlüsse der Transistoren P2 und P3 jeweils mit einer Reihenschaltung aus einem p-Kanaltransistor P4 bzw. P5 und einem n-Kanaltransistor N2 bzw. N3 verbunden. Die Gateanschlüsse der p=Kanaltransistoren P4 und P5 sind jeweils mit dem ersten Versorgungspotential Vₛₛ verbunden. Der Gate-Anschluss des n-Kanaltransistors N2 ist direkt, der Gate-Anschluss des n-Kanaltransistors N3 über einen Inverter INV an den Schalteingang 1 des Pegelumsetzers 6 angeschlossen. Der Invertierer INV invertiert das am Schalteingang 1 anliegende Schaltsignal. Der Drainanschluss des p-Kanaltransistors P4 und somit der Drain-Anschluss des n-Kanaltransistors N2 sind zum einen mit dem Gate-Anschluss des einen Transistors N1 des Schalters 4 und zum anderen über eine Steuer-Koppelkapazität C2 mit dem ersten Versorgungspotential V_{SS} verbunden. Der Drain-Anschluss des p-Kanaltransistors P5 und somit der Drain-Anschluss des n-Kanaltransistors N3 führen zu dem weiteren Transistor P1 des Schalters 4.

Liegt am Schalteingang 1 des Pegelumsetzers 6 ein Signal unterhalb einer bestimmten Schaltschwelle an, so wird der n-Kanaltransistor N3, nachdem das Schaltsignal vom Inverter INV interviert ist, durchgeschaltet. Aufgrund der Kreuzkopplung liegt dann am Gate-Anschluss des p-Kanaltransistors P2 das erste Versorgungspotential V_{SS} an und der p-Kanaltransistor P2 schaltet ebenfalls durch. Da der n-Kanaltransistor N2, an dessen Gate-Anschluss ebenfalls das Schaltsignal anliegt, sperrt, nimmt der Gate-Anschluss des n-Kanaltransistors N1 des Schalters 4 das zweite Versorgungspotential V_{CC} an. Gleichzeitig nimmt der p-Kanaltransistor P1 des Schalters 4 das erste Versorgungspotential Vss an, da der n-Kanaltransistor N3 durchgeschaltet ist. Sowohl der n-Kanaltransistor N1 als auch der p-Kanaltransistor P1 des Schalters 4 sind durchgeschaltet. Der Schalter 4 ist also in diesem Fall geschlossen.

Bei einem Schaltsignal, das über der Schaltschwelle liegt, ist der n-Kanaltransistor N2 durchgeschaltet und der n-Kanaltransistor N3 gesperrt. Am Gate-Anschluss des p-Kanaltransistors P3 liegt das erste Versorgungspotential V_{SS} an und der Transistor P3 schaltet durch. Das bewirkt, dass der Gate-Anschluss des p-Kanaltransistors P1 des Schalters 4 das zweite Versorgungspotential V_{CC} annimmt und sperrt. Der n-Kanaltransistor N1 des Schalters 4 sperrt ebenfalls, da an dessen Gate-Anschluss das erste Versorgungspotential V_{SS} anliegt.
In diesem Fall ist also der Schalter 4 geöffnet.

Durch die Ausführung des Schalters 4 mit zwei parallelgeschalteten Transistoren N1, P1 wird erreicht, dass im zweiten Betriebsmodus der Spannungsgenerator 2 praktisch vollständig von der Vorrichtung 10 getrennt ist. Schwankungen der internen Versorgungsspannung haben daher auf die externe Referenzspannung V_{ref,ext.} kaum Einfluss.

Zur weiteren Stabilisierung der erfindungsgemäßen Schaltungsanordnung gegenüber Störungen sind die Koppelkapazitäten C1 und C2 sowie die p-Kanaltransistoren P4 und P5 vorgesehen. Durch die Ausgangskoppelkapazität C1 wird eine starke Kopplung der internen Referenzspannung V_{ref,int.} am Ausgangsanschluss 3 des Spannungsgenerators 2 mit dem ersten Versorgungspotential V_{SS} hergestellt. Da das erste Versorgungspotential V_{SS} das Bezugspotential darstellt, ist eine große Kopplung erwünscht. Ebenso ist der Steueranschluss des Schalters 4, konkret der Gate-Anschluss des n-Kanaltransistors N1 des Schalters 4, über die Steuerkoppelkapazität C2 mit dem ersten Versorungspotential V_{SS} gekoppelt. Der Einfluss transienter Störgrößen auf die interne Referenzspannung V_{ref,int.} oder den Steueranschluss des Schalters 4 werden durch die integrierende Wirkung der Koppelkapazitäten deutlich herabgesetzt.

Die p-Kanaltransistoren P4 und P5 stellen aufgrund der parasitären Kapazitäten jeweils zwischen Drain und Gate und Source und Gate einen kapazitiven Teiler dar. Dadurch wird erreicht, dass das vom Bezugspotential verschiedene zweite Versorgungspotential Vcc nur gering mit der internen Referenzspannung V_{ref,int.} verkoppelt ist. Auswirkungen kurzzeitiger Schwankungen des zweiten Versorgungspotentials V_{CC} auf die interne Referenzspannung V_{ref,int.} werden gering gehalten.

Die Kapazitäten der Koppelkapazitäten C1 und C2 liegen um Größenordnungen über den Kapazitäten der p-Kanaltransistoren P4 und P5.

## Patentansprüche

1. Schaltungsanordnung, umfassend:
- eine Schaltstufe (10) mit einem Eingang (9) zum Empfang eines digitalen Eingangssignals und mit einem Ausgang (11) zur Abgabe eines digitalen Ausgangssignals, wobei die Schaltstufe (10) das Ausgangssignal in Abhängigkeit eines Vergleichs des Eingangssignals mit einem Referenzsignal (V_{ref.int.}; V_{ref,ext.}) erzeugt und wobei das Referenzsignal aus einem aus einem ersten Steueranschluß (8) anliegenden externen Referenzsignal (V_{ref,ext.})und einem an einem weiteren Spannungsanschluß (7) anliegenden internen Referenzsignal (V_{ref,int.}) auswählbar ist;
- einem Schalter (4) der zwischen den zweiten Spannungsanschluß (7) und einen Spannungsgenerator (2), der das interne Referenzsignal (V_{ref,int.})erzeugt, geschaltet ist;
- einen Pegelumsetzer (6) mit einem Schalteingang (1) zum Empfang eines Schaltsignals (V) und einem Steuerausgang (5), der den Schalter (4) ansteuert, und mit zwei Strompfaden, die zwischen einen Anschluß für ein erstes Versorgungspotential (Vₛₛ) und einen Anschluß für ein zweites Versorgungspotential (Vcc) geschaltet sind; wobei
- jeder der Strompfade eine Reihenschaltung der Kanalstrecken eines ersten Transistors (P2, P3), eines zweiten Transistors (P4, P5) jeweils eines ersten Leitungstyps und eines dritten Transistors (N2, N3) eines anderen zweiten Leitungstyps aufweist und die Gate-Anschlüsse der ersten Transistoren (P2, P3) mit den Kanalstrecken des jeweils anderen der ersten Transistoren (P3, P2) kreuzgekoppelt verbunden sind, die Gate-Anschlüsse der zweiten Transistoren (P4, P5) mit dem Anschluß für das erste Versorgungspotential (V_{SS}) verbunden sind, der Gate-Anschluß eines der dritten Transistoren (N2) mit dem Schalteingang (1) des Pegelumsetzers verbunden ist, der Gate-Anschluß des anderen der dritten Transistoren (N3) über einen Inverter (INV) mit dem Schalteingang (1) des Pegelumsetzer verbunden ist und der Steuerausgang (5) des Pegelumsetzers mit den Kanalstrecken der dritten Transistoren (N2, N3) verbunden ist.

2. Schaltungsanordnung nach Anspruch 1,
**dadurch gekennzeichnet, daß**
der Schalter (4) einen Schalttransistor (P1) des ersten Leitungstyps und einen Schalttransistor (N1) des zweiten Leitungstyps aufweist und daß die Schaltransistoren (P1, N1) des Schalters (4) kanalseitig parallel geschaltet sind.

3. Schaltungsanordnung nach Anspruch 1 oder 2,
**dadurch gekennzeichnet, daß**
der Steuerausgang (5) des Pegelumsetzers eine Signalleitung umfaßt, die mit der Kanalstrecke eines der dritten Transistoren (N2) verbunden ist, und daß diese Signalleitung über eine Steuer-Koppelkapazität (C2) mit dem Anschluß für das erste Versorgungspotential (V_{SS}) verbunden ist.

4. Schaltungsanordnung nach einem der Ansprüche 1 bis 3,
**dadurch gekennzeichnet, daß**
eine Ausgangs-Koppelkapazität (C1) zwischen einen Ausgang des Spannungsgenerators (2) und dem Anschluß für das erste Versorgungspotential (V_{SS}) geschaltet ist.

## Claims

1. Circuit arrangement comprising:
- a switching stage (10) having an input (9) for receiving a digital input signal, and having an output (11) for outputting a digital output signal, the switching stage (10) generating the output signal as a function of a comparison of the input signal with a reference signal (V_{ref,int.}; V_{ref,ext.}), and the reference signal being selectable from a external reference signal (V_{ref,ext.}) which is present at a first control terminal (8) and an internal reference signal (V_{ref.int.}) which is present at a further voltage terminal (7);
- a switch (4) which is connected between the second voltage terminal (7) and a voltage generator (2) which generates the internal reference signal (V_{ref,int.}) ;
- a level converter (6) having a switching input (1) for receiving a switching signal (V) and a control output (5) which actuates the switch (4), and having two current paths which are connected between a terminal for a first supply potential (V_{SS}) and a terminal for a second supply potential (V_{CC});
- each of the current paths having a series connection of the channel paths of a first transistor (P2, P3), of a second transistor (P4, P5), each of a first conduction type, and of a third transistor (N2, N3) of another second conduction type, and the gate terminals of the first transistors (P2, P3) being cross-coupled to the channel paths of the respective other of the first transistors (P3, P2), the gate terminals of the second transistors (P4, P5) being connected to the terminal for the first supply potential (V_{SS}) , the gate terminal of one of the third transistors (N2) being connected to the switching input (1) of the level converter, the gate terminal of the other of the third transistors (N3) being connected to the switching input (1) of the level converter via an inverter (INV), and the control output (5) of the level converter being connected to the channel paths of the third transistors (N2, N3).

2. Circuit arrangement according to Claim 1, **characterized in that** the switch (4) has a switching transistor (P1) of the first conduction type and a switching transistor (N1) of the second conduction type, and **in that** the switching transistors (P1, N1) of the switch (4) are connected in parallel on the channel side.

3. Circuit arrangement according to Claim 1 or 2, **characterized in that** the control output (5) of the level converter comprises a signal line which is connected to the channel path of one of the third transistors (N2), and **in that** this signal line is connected to the terminal for the first supply potential (V_{SS}) via a control coupling capacitor (C2).

4. Circuit arrangement according to one of Claims 1 to 3, **characterized in that** an output coupling capacitor (C1) is connected between an output of the voltage generator (2) and the terminal for the first supply potential (V_{SS}).

## Revendications

1. Montage comprenant :
- un étage (10) de commutation, ayant une entrée (9) de réception d'un signal d'entrée numérique et une sortie (11) d'émission d'un signal de sortie numérique, l'étage (10) de commutation produisant le signal de sortie en fonction d'une comparaison du signal d'entrée avec un signal (V_{ref,int.}; V_{ref,ext.}) de référence et le signal de référence pouvant être choisi parmi un signal (V_{ref} _{ext.}) de référence extérieur s'appliquant à une première borne (8) de commande et un signal (V_{ref int.}) de référence intérieur s'appliquant à une autre borne (7) de tension ;
- un commutateur (7) qui est monté entre la deuxième borne (7) de tension et un générateur (2) de tension, qui produit le signal (V_{ref int.}) de référence intérieur ;
- un changeur (6) de niveau; ayant une entrée (1) de commutation de réception d'un signal (5) de commutation et une sortie (5) de commande, qui commande le commutateur (4), et ayant deux trajets de courant qui sont montés entre une borne pour un premier potentiel (V_{SS}) d'alimentation et une borne pour un deuxième potentiel (V_{CC}) d'alimentation ; dans lequel
- chacun des trajets de courant comporte un circuit série des sections de canal d'un premier transistor (P2, P3), d'un deuxième transistor (P4, P5) respectivement d'un premier type de conductivité et d'un troisième transistor (N2, N3) d'un autre second type de conductivité et les bornes de grille des premiers transistors (P2, P3) sont reliées en croix aux sections de canal de respectivement l'autre des premiers transistors (P3, P2), les bornes de grille des deuxièmes transistors (P4, P5) son reliées à la borne pour le premier potentiel (V_{SS}) d'alimentation, la borne de grille d'un des troisièmes transistors (N2) est reliée à l'entrée (1) du commutation du changeur de niveau, la borne de grille de l'autre des troisièmes transistors (N3) est reliée par l'intermédiaire d'un inverseur (INV) à l'entrée (1) de commutation du changeur de niveau et la sortie (5) de commande du changeur de niveau est reliée aux sections de canal des troisièmes transistors (N2, N3).

2. Montage suivant la revendication 1,
**caractérisé en ce que**
le commutateur (4) comporte un transistor (P1) de commutation du premier type de conductivité et un transistor (N1) de commutation du second type de conductivité et **en ce que** les transistors (P1 et N1) de commutation du commutateur (4) sont montés en parallèle du côté canal.

3. Montage suivant la revendication 1 ou 2,
**caractérisé en ce que**
la sortie (5) de commande du changeur de niveau comprend une ligne de signal, qui est reliée à la section du canal de l'un des troisièmes transistors (N2) et **en ce que** cette ligne de signal est reliée par une capacité (C2) de commande-couplage à la borne pour le premier potentiel (V_{SS}) d'alimentation.

4. Montage suivant l'une des revendications 1 à 3,
**caractérisé en ce que**
une capacité (C1) de couplage de sortie est montée entre une sortie du générateur (2) de tension et la borne pour le premier potentiel (V_{SS}) d'alimentation.
